# EUROPÄISCHE PATENTSCHRIFT

(11) **EP 4 081 813 B1**
(45) Veröffentlichungstag und Bekanntmachung des Hinweises auf die Patenterteilung: **21.10.2026**
(21) Anmeldenummer: 20810908.2
(22) Anmeldetag: 18.11.2020
(51) Int. Cl.: G01R 27/26, B60R 21/017, G01R 31/00, G01R 31/64, G01R 31/01

(54) **VERFAHREN, COMPUTERPROGRAMM, ELEKTRONISCHES SPEICHERMEDIUM UND VORRICHTUNG ZUR ERKENNUNG DES ABRISSES EINER ENERGIERESERVEEINRICHTUNG**
METHOD, COMPUTER PROGRAM, ELECTRONIC STORAGE MEDIUM AND DEVICE FOR DETECTING THE BREAKDOWN OF AN ENERGY RESERVE UNIT
PROCÉDÉ, PROGRAMME INFORMATIQUE, SUPPORT DE STOCKAGE ÉLECTRONIQUE ET DISPOSITIF DE DÉTECTION DE CLAQUAGE D'UNE UNITÉ DE RÉSERVE D'ÉNERGIE

(30) Priorität: 23.12.2019 DE 102019220536
(43) Veröffentlichungstag der Anmeldung: 02.11.2022
(73) Patentinhaber: Robert Bosch GmbH, 70442 Stuttgart (DE)
(72) Erfinder: GRASI, Florian, 74081 Heilbronn (DE); SCHUMACHER, Hartmut, 71691 Freiberg (DE); WILLKE, Clemens, 71720 Oberstenfeld (DE); LIST, Carsten, 74399 Walheim (DE)
(86) Internationale Anmeldenummer: PCT/EP2020/082532
(87) Internationale Veröffentlichungsnummer: WO 2021/129982

(56) Entgegenhaltungen:
- EP-A1- 1 870 289
- EP-A1- 3 006 244
- EP-A2- 2 658 079
- WO-A1-89/06366
- DE-A1- 102010 028 556
- DE-A1- 102014 207 171
- DE-A1- 102017 221 096
- DE-A1- 19 517 698
- DE-T5- 112017 007 371
- JP-A- 2008 235 155
- US-A1- 2011 018 551
- US-A1- 2012 025 613

## Beschreibung

**Die vorliegende** Erfindung schafft ein Verfahren, ein Computerprogramm, ein elektronisches Speichermedium sowie eine Vorrichtung zur Erkennung des Abrisses einer Energiereserveeinrichtung von mindestens zwei Energiereserveeinrichtungen einer Vorrichtung für den Insassenschutz eines Fahrzeugs.

### Stand der Technik

Aus der DE 37 44 524 A1 ist ein Verfahren zum Testen der Einsatzfähigkeit einer Energiereserveeinrichtung für eine Vorrichtung zur Steuerung einer Insassenschutzvorrichtung eines Fahrzeugs bekannt.

Dabei wird zur Überprüfung der Kapazität einer Energiereserveeinrichtung (Kondensator) dieser ausgehend von einem ersten Spannungswert (U_{S1}) mit einem konstanten Entladestrom (I_{K}) bis auf einen vorgegebenen zweiten Spannungswert (U_{S2}) entladen. Die Entladezeit (t_{E}) wird gemessen. Bei bekanntem Ladewiderstand (R_{E}) lässt sich aus den gemessenen Werten die aktuelle Kapazität der Energiereserveeinrichtung errechnen.

Vorrichtungen zur Steuerung von Fahrzeuginsassenschutzsystemen (Airbagsysteme) werden so ausgelegt, dass alle bekannten Standardkollisionen auch bei Unterbrechung der Energieversorgung immer aus einer Energiereserveeinrichtungen unter Berücksichtigung aller Toleranzen bedient werden können und die vorgesehenen Insassenschutzmittel, wie bspw. Rückhaltemittel (Airbags) aktiviert werden können, sowie die notwendigen Informationen im Zusammenhang mit der Kollision in einem Datenspeicher (Electronic Data Recorder; EDR) gespeichert werden können.

Die dazu eingesetzte Energiereserveeinrichtung besteht bei mittleren und größeren Systemen in der Regel aus zwei oder mehr Elektrolytkondensatoren. Diese Elektrolytkondensatoren weisen herstellungsbedingt eine große Kapazitätstoleranz auf. Typische Werte sind dabei zwischen 0 % und 30 % Nominaltoleranz bei Anlieferung. Eine Temperaturabhängigkeit von ca. 15 % im Temperaturbereich von - 40 °C bis + 105 °C sowie eine altersbedingte Abnahme der Kapazität um ca. 10 % für eine äquivalente Belastung von 2000 h bei 105 °C, sowie einen DC Faktor (1,0 bis 1,3) als Verhältnis der Gleichstromkapazität zur standardisiert gemessenen Nominalkapazität bei Wechselstrom mit 120 Hz. Aus EP 1 870 289 A1 ist ein Verfahren bekannt, bei dem die Degradierung eines Energiespeichers bestehend aus Kondensatoren erfasst wird.

### Offenbarung der Erfindung

Vor diesem Hintergrund schafft die vorliegende Erfindung ein Verfahren zur Erkennung des Abrisses einer Energiereserveeinrichtung von mindestens zwei parallel geschalteten Energiereserveeinrichtungen einer Vorrichtung zur Steuerung eines Insassenschutzsystems eines Fahrzeugs gemäß Anspruch 1.

Die Erkennung des Abrisses eines Elektrolytkondensators in Systemen mit nur einem Elektrolytkondensator ist bereits bekannt.

Bei Systemen mit zwei oder mehr parallelgeschalteten Elektrolytkondensatoren funktionieren die bekannten Ansätze nicht. Dies kann daran liegen, dass die Nominalkapazitäten der einzelnen Kondensatoren unterschiedlich sein können. Doch selbst in Systemen mit zwei oder mehr parallelgeschalteten Elektrolytkondensatoren mit im Wesentlichen gleicher Nominalkapazität reichen die fertigungsbedingten Kapazitätstoleranzen bereits aus, dass die bekannten Verfahren zur Abrisserkennung nicht mit der erforderlichen Verlässlichkeit anwendbar sind.

Daher ist es Aufgabe der vorliegenden Erfindung, in Systemen mit zwei und mehr parallelgeschalteten Elektrolytkondensatoren als Energiereserve den mechanischen Verlust durch Abriss (bspw. aufgrund von Vibrationen udgl.) zu erkennen und durch Ansteuerung geeigneter Hinweisvorrichtungen, wie bspw. einer Warnlampe, oder anderen Serviceinformationen die Behebung des Fehlers bzw. Durch den Austausch des Steuergerätes, zu veranlassen, obwohl der Minimalwert an Energiereserve zu Erfüllung aller Anforderungen nicht bzw. noch nicht unterschritten ist.

Dadurch können Störungen an der Elektronik/Sensorik durch Bewegung einer relativ schweren Komponente (typisches Gewicht eines Elektrolytkondensators: ca. 10 g bis 20 g) vorgebeugt werden, noch bevor eine solche Störung negative Auswirkungen auf Einsatzfähigkeit der Steuervorrichtung im Falle einer Kollision hat.

Diese Aufgabe wird durch das Verfahren der vorliegenden Erfindung gelöst. Dazu umfasst das Verfahren die Schritte:
Laden der mindestens zwei Energiereserveeinrichtungen auf ein Testspannungsniveau (V_Test);
Ermitteln einer Umgebungstemperatur der mindestens zwei Energiereserveeinrichtungen;
Erfassen der (Gesamt) Kapazität der mindestens zwei Energiereserveeinrichtungen;
Erkennung des Abrisses einer Energiereserveeinrichtung in Abhängigkeit von einem von der ermittelten Umgebungstemperatur abhängigen gleitenden Mittelwert für die Gesamtkapazität und der erfassten Gesamtkapazität;
Aktualisierung eines gleitenden Mittelwerts in Abhängigkeit von der ermittelten Umgebungstemperatur und der erfassten Gesamtkapazität;
Die vorliegende Erfindung basiert auf der Erkenntnis, dass die Kapazitäten der Energiereserveeinrichtungen temperaturabhängig sind. Durch die Berücksichtigung der Umgebungstemperatur der Energiereserveeinrichtungen ist es daher in vorteilhafter Weise möglich die Änderung der Kapazitätsmesswerte von Fahrzeugstart zu Fahrzeugstart temperaturabhängig zu erfassen und anhand einer Abweichung des aktuellen temperaturabhängigen Kapazitätswerts mit einem mittleren Kapazitätswert unter einer im Wesentlichen gleichen Temperaturbedingung den Abriss mindestens eines der mindestens zwei Elektrolytkondensatoren sicher und zuverlässig zu erkennen.

Nach einer Ausführungsform des Verfahrens der vorliegenden Erfindung wird im Schritt des Ermittelns der Umgebungstemperatur ein Temperaturwert eines Temperatursensors einer Sensoreinheit der Vorrichtung erfasst.

Unter einer Sensoreinheit ist vorliegend ein Sensor zu verstehen, der nicht primär ein Temperatursensor ist. Typischerweise weisen Vorrichtungen zur Steuerung von Fahrzeuginsassenschutzmitteln (Airbagsteuergeräte) Sensoren zur Erfassung der auf das Fahrzeug einwirkenden Kräfte (i. W. Beschleunigungs- und Drehratensensoren) auf. Diese Sensoren sind Sensoreinheiten im Sinne der vorliegenden Erfindung. Diese Sensoren können eine Schaltung aufweisen, die dazu fähig ist einen Temperaturwert zu erfassen. Diese Ausführungsform des Verfahrens der vorliegenden Erfindung nutzt zur Ermittlung der Umgebungstemperatur eine solche Schaltung eines solchen Sensors. Dabei basiert diese Ausführungsform auf der Erkenntnis, dass einerseits die exakte Umgebungstemperatur der Energiereserveeinrichtung für das Verfahren nicht erforderlich ist und andererseits, dass ein solcher Sensor in unmittelbarer Nähe der Energiereserveeinrichtung oder zumindest im gleiche Gehäuse der Steuervorrichtung angeordnet ist und daher einen ausreichend verlässlichen Temperaturwert für die Umgebungstemperatur der Energiereserveeinrichtung bereitstellen kann.

Nach einer Ausführungsform des Verfahrens der vorliegenden Erfindung wird im Schritt des Ermittelns der Umgebungstemperatur ein Temperaturwert eines Temperatursensors erfasst, der eine Innenraumtemperatur des Fahrzeugs erfasst.

Der Vorteil dieser Ausführungsform ist, dass ein Temperaturwert einer Innenraumtemperatur des Fahrzeugs in vielen Fahrzeugen, insbesondere in Fahrzeugen mit einem Klimagerät, bereits vorhanden ist und in einfacher Art und Weise über eine vorhandene Kommunikationsschnittstelle (bspw. über CAN, CAN-FD, FlexRay, Ethernet udgl.) auf diesen Wert zugegriffen werden kann.

Obwohl der Temperaturwert der Innenraumtemperatur nicht den exakten Wert der Umgebungstemperatur der Energiereserveeinrichtung darstellt, ist dieser Temperaturwert ausreichend verlässlich für die Ausführung der vorliegenden Erfindung.

Nach einer Ausführungsform des Verfahrens der vorliegenden Erfindung wird im Schritt des Ermittelns der Umgebungstemperatur in Abhängigkeit von den erfassten Temperaturwerten eine Temperaturklasse bestimmt.

Diese Ausführungsform basiert auf der Erkenntnis, dass es zur verlässlichen Erkennung des Abrisses mindestens einer Energiereserveeinrichtung von mindestens zwei Energiereserveeinrichtungen für eine Vorrichtung zur Steuerung von Insassenschutzmitteln eines Fahrzeugs die Umgebungstemperatur der Energiereserveeinrichtungen einer Temperaturklasse zuzuordnen und die temperaturabhängige Kapazitätsmessung und den temperaturabhängigen Vergleich auf Basis der zugeordneten Temperaturklasse durchzuführen.

Diese Ausführungsform basiert auf der Erkenntnis, dass mit einer vergleichsweise geringen Anzahl an Temperaturklassen, bspw. lediglich drei für die Temperaturbereiche niedrig (- 40 °C bis 0 °C), normal (0 °C bis + 40 °C), hoch (+40 °C bis + 80 °C), eine verlässliche Erkennung des Abrisses einer Energiereserveeinrichtung möglich ist.

Dadurch birgt diese Ausführungsform den Vorteil, dass einerseits wenige Mittelwerte vorgehalten werden müssen, nämlich lediglich für jede Temperaturklasse einen und andererseits, dass eine Aktualisierung der Mittelwerte leicht möglich ist, da für jeden Temperaturbereich ausreichend verlässlich Temperaturwerte ermittelt werden, die dann für die Bildung des Mittelwerts berücksichtigt werden können.

Nach einer Ausführungsform des Verfahrens der vorliegenden Erfindung wird im Schritt des Aktualisierens die erfasste Gesamtkapazität nur zur Aktualisierung des gleitenden Mittelwerts berücksichtigt, wenn die ermittelte Umgebungstemperatur unterhalb eines vorgegebenen Schwellenwerts für die Umgebungstemperatur liegt.

Liegt der Temperaturwert der Umgebungstemperatur über einem vorgegebenen Schwellenwert, so wirkt sich diese hohe Umgebungstemperatur in einer Weise auf die Toleranzen der Energiereserveeinrichtungen aus, dass eine sinnvolle Messung der Kapazitäten nicht aufwandsgerecht durchgeführt werden kann. Damit ist es auch nicht sinnvoll den bei einer solchen Umgebungstemperatur erfassten Kapazitätswert für die Aktualisierung des temperaturabhängigen gleitenden Mittelwerts zu berücksichtigen.

Nach einer Ausführungsform des Verfahrens der vorliegenden Erfindung wird im Schritt des Aktualisierens die erfasste Gesamtkapazität nur zur Aktualisierung des gleitenden Mittelwerts berücksichtigt, wenn die erfasste Gesamtkapazität innerhalb eines vorgegebenen Toleranzbereichs für die mindestens zwei Energiereserveeinrichtungen liegt.

Liegt die aktuell erfasste Kapazität nicht innerhalb des vorgegebenen Toleranzbereichs für die Kapazitäten, so ist es unerheblich, ob ein Abriss einer Energiereserveeinrichtung vorliegt, da in einem solchen Fall ein schwerwiegender Fehler der gesamten Energiereserveeinrichtungen vorliegt. In einem solchen Fall ist es nicht sinnvoll den bei einer solchen Umgebungstemperatur erfassten Kapazitätswert für die Aktualisierung des temperaturabhängigen gleitenden Mittelwerts zu berücksichtigen.

Nach einer Ausführungsform des Verfahrens der vorliegenden Erfindung wird im Schritt des Aktualisierens die erfasste Gesamtkapazität nur zur Aktualisierung des gleitenden Mittelwerts berücksichtigt, wenn die erfasste (Gesamt)Kapazität innerhalb eines vorgegebenen Toleranzbereichs für den von der ermittelten Umgebungstemperatur abhängigen gleitenden Mittelwert für die Gesamtkapazität liegt.

Die temperaturabhängige Erfassung der Kapazität hat eine endliche Größe, daher werden die individuellen Kapazitätsmesswerte eines Steuergerätes auch entsprechend streuen. Ist der Streuwert zu hoch, deutet dies auf eine spezielle Situation hin, die zu einer Störung der Messung führen konnte. Ein solcher Messwert kann durch diese Ausführungsform erkannt werden und dementsprechend nicht für die Aktualisierung des temperaturabhängigen gleitenden Mittelwerts zu berücksichtigt werden.

Die drei vorstehenden Ausführungsformen basieren auf der Erkenntnis, dass der temperaturabhängige gleitende Mittelwert der Kapazitäten der vorherigen Fahrzeugstarts eine zentrale Größe für die Erkennung des Abrisses einer Energiereserveeinrichtung ist. Um das Verfahren robuster zu gestalten, müssen aktuell erfasste Kapazitätswerte eine beliebige Kombination der vorstehenden Bedingungen erfüllen, um bei der Bildung des gleitenden Mittelwerts berücksichtigt zu werden. Durch diese Ausführungsformen kann effektiv verhindert werden, dass der temperaturabhängige gleitende Mittelwert durch einzelne Ausreißer bei der Erfassung der aktuellen Kapazität verwässert wird.

Ein weiterer Aspekt der vorliegenden Erfindung ist eine Vorrichtung, welche derart eingerichtet ist, alle Schritte des Verfahrens gemäß der vorliegenden Erfindung auszuführen.

Ein weiterer Aspekt der vorliegenden Erfindung ist ein Computerprogramm, umfassend Befehle, die bewirken, dass die oben genannte Vorrichtung alle Schritte des Verfahrens gemäß der vorliegenden Erfindung ausführt.

Ein weiterer Aspekt der vorliegenden Erfindung ist ein elektronisches Speichermedium, auf dem das Computerprogramm gemäß der vorliegenden Erfindung gespeichert ist.

Nachfolgenden werden Ausführungsformen der vorliegenden Erfindung anhand von Zeichnungen näher erläutert.

Es zeigt:

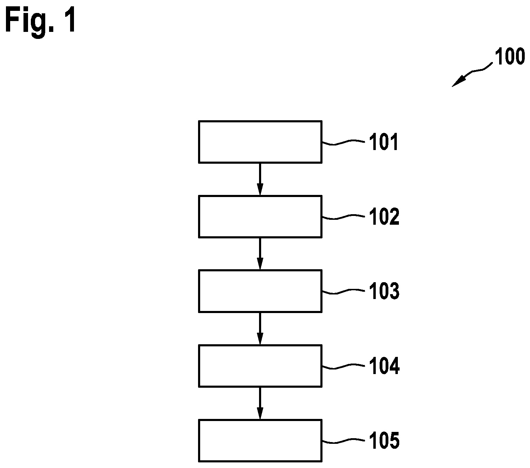

- Fig. 1: ein Ablaufdiagramm einer Ausführungsform des Verfahrens der vorliegenden Erfindung;

Figur 1 zeigt ein Ablaufdiagramm einer Ausführungsform des Verfahrens 100 der vorliegenden Erfindung.

Das Verfahren beginnt in einem Zustand, in dem die Energiereserveeinrichtungen ER auf ein vorgegebenes Sollspannungsniveau VER zum Betrieb der der Vorrichtung zur Steuerung von Insassenschutzmitteln von Fahrzeugen (Airbagsteuergerät) geladen sind.

In Schritt 101 erfolgt das Laden der mindestens 2 Energiereserveeinrichtungen ER auf eine vorgegebene Sollspannung für den Kapazitätstest V_TEST. Bei den Energiereserveeinrichtungen ER kann es sich um Elektrolytkondensatoren handeln. Die Sollspannung für den Kapazitätstest V_TEST kann bspw. 11 V betragen. Die Steuerung des Ladens kann durch den Mikrocontroller µC des Airbagsteuergeräts erfolgen. Der µC kann durch das Übermitteln entsprechender Steuerbefehle mittels eines SPI (Serial Peripheral Interface) an eine Ladeschaltung zum Laden der Energiereserveeinrichtungen ER das Laden steuern.

In Schritt 102 noch vor dem Start der eigentlichen Kapazitätsmessung erfolgt die Ermittlung der Umgebungstemperatur der mindestens zwei Energiereserveeinrichtungen ER.

Hierzu kann der µC über das SPI die Temperatur des System-ASIC auslesen. Der System-ASIC ist dabei neben dem µC eine zentrale Rechenressource des Airbagsteuergeräts. Typischerweise umfasst ein System-ASIC eines Airbagsteuergeräts eine Schaltung zur Erfassung eines Temperaturwerts des System-ASIC. Da der System-ASIC und die Energiereserveeinrichtungen ER typischerweise in unmittelbarer Nähe zueinander, zumindest innerhalb des gleichen Gehäuses des Airbagsteuergeräts, angeordnet sind, kann dieser Temperaturwert zur Ermittlung der Umgebungstemperatur der mindestens zwei Energiereserveeinrichtungen herangezogen werden. Anstelle eines System-ASIC kann auch ein zweiter ggf. redundant ausgelegter µC oder ein Mikroprozessor µP in dem Airbagsteuergerät angeordnet sein.

Der ausgelesene Temperaturwert des System-ASIC gibt abzüglich der Eigenerwärmung des ASIC die Umgebungstemperatur der mindestens 2 Energiereserveeinrichtungen wieder.

Alternativ oder zusätzlich kann der µC auch auf einen oder alle Temperatursensoren der verwendeten Sensoreinheiten innerhalb des Gehäuses des Airbagsteuergeräts zugreifen. Diese geben nahezu ohne Korrektur die Steuergeräteinnentemperatur wieder, da kaum Eigenerwärmung vorliegt.

Alternativ oder zusätzlich kann über ein Kommunikationsinterface (wie bspw. CAN, CAN-FD, FlexRay, Ethernet udgl.) auf den Temperaturwert des Innenraums des Fahrzeugs zugegriffen werden.

Mit der ermittelten Umgebungstemperatur vor dem Start der eigentlichen Kapazitätsmessung dient der Festlegung der temperaturabhängigen Abrisserkennung gemäß der vorliegenden Erfindung.

In Schritt 103 erfolgt das Erfassen der Kapazität der mindestens zwei Energiereserveeinrichtungen ER. Die Erfassung erfolgt durch das Anlegen eines geeigneten Ladestroms für eine geeignete Erfassungszeit. Die Parameter Ladestrom und Erfassungszeit sind stark von der Auslegung der Energiereserveeinrichtungen ER und der Ladeschaltung abhängig. Da es sich dabei an sich um die gleichen Parameter handelt, wie bei der bekannten Kapazitätsmessung eines einzelnen Elektrolytkondensators, liegt es im Bereich des fachmännischen Könnens den geeigneten Ladestrom und die geeignete Erfassungszeit festzulegen. Diese Parameter werden von dem µC im Rahmen der Steuerung der Messung festgelegt und bspw. per SPI an die Lade- bzw. Messschaltung übermittelt.

Eine Möglichkeit zur Erfassung der Kapazität ist der Vergleich der Spannung der Energiereserveeinrichtungen unmittelbar vor Anlage des Ladestroms für die Messung mit der Spannung der Energiereserveeinrichtungen unmittelbar nach Ablauf der geeigneten Messzeit. Aus der Differenz der Spannungen lässt sich direkt die Kapazität der Energiereserveeinrichtungen ermitteln. Die erfassten Spannungen können dafür für den Vergleich nach einer Digitalisierung in geeigneten Registern des µC abgelegt werden.

Denkbar ist im Schritt der Erfassung der Kapazität die erfasste Kapazität auf Einhaltung vorgegebenen Minimal- und Maximalschwellenwerte für die Kapazität zu prüfen.

Der ermittelte Kapazitätswert Wert muss in einem zulässigen Bereich liegen, der durch Minimal- Cgₘᵢₙ und Maximalschwellenwerte Cgₘₐₓ für die Gesamtkapazität bestimmt wird.

Beispiel: Energiereserveeinrichtung mit 6 parallel geschalteten Elektrolytkondensatoren mit einer Nominalkapazität bei 120 Hz Cn von je 4,5 mF. Die Gesamtnominalkapazität Cgn beträgt damit Cgn = 6 x 4,5 mF =27 mF. Die Nominaltoleranz stammt aus 0 % bis 30 %; die Cgn Temperaturabhängigkeit liebt bei ca. +/- 5 %, die Mess-Stromtoleranz bei +/- 10 %, die ER Differenz-Spannungsmesstoleranz bei + / -1%; die ADC Genauigkeit +/- 1 digit ≈ +/- 2,5 %; der ER Leck-Strom im Messaugenblick zwischen 0 % und 10%, die Toleranz des DC Kapazitätswertes im Verhältnis zum AC Nominalwert = 1,0 bis 1,3; durch Alterung sind weitere 0 bis 10 % Toleranz zu berücksichtigen.

Damit Beträgt der Maximalschwellenwert Cgₘₐₓ = 1.3 x 1.05 x 1.10 x 1.01 x 1.025 x 1.1 x 1.30 x 27 mF = 60 mF;
Der Minimalschwellen wert Cgₘᵢₙ = 1 x 0.95 x 0.9 x 0.99 x 0.975 x 1 x 1 x 0.9 = 20 mF.

Liegt die erfasste Kapazität außerhalb des vorgegebenen Bereichs liegt unabhängig davon, ob ein Abriss einer Energiereserveeinrichtung besteht ein Fehler in den Energiereserveeinrichtungen vor, der eine geeignete Fehlerbehandlung erfordert.

Eine solche Fehlerbehandlung kann dabei in der Wiederholung der Kapazitätsmessung bestehen. Denkbar ist, dass eine festgelegte Maximalanzahl für die Wiederholung der Kapazitätsmessung vorgegeben werden kann, bevor die Fehlerbehandlung in eine höhere Eskalationsstufe eintritt. In einer höheren Stufe kann das Ausgeben eines Warnhinweises bspw. durch die Ansteuerung einer Warnlampe erfolgen, die zum Besuch einer geeignet ausgestatteten Werkstatt auffordert, vorgesehen sein.

In Schritt 104 erfolgt die Erkennung eines Abrisses einer Energiereserveeinrichtung. Die Erkennung erfolgt gemäß der vorliegenden Erfindung durch einen Vergleich der aktuell temperaturabhängig erfassten Kapazität der Energiereserveeinrichtung mit einem temperaturabhängigen Mittelwert der Kapazitäten. Ein Abriss wird dann erkannt, wenn die aktuell erfasste Kapazität über eine vorgegebenen Schwellenwert AB_LIMIT hinweg unterhalb des temperaturabhängigen Mittelwerts der Kapazitäten liegt. Da eine solche Abweichung nicht auf temperaturbedingte Toleranzen der Energiereserveeinrichtungen zurückzuführen ist, sondern von einem Abriss einer Energiereserveeinrichtung der mindestens zwei Energiereserveeinrichtungen zurückzuführen ist.

Für die Erkennung gilt dann nachstehender Zusammenhang:
*Cg*(ϑ*x, k) ε] Cgₘᵢₙ(ϑx, k-1), MWg_ CG(ϑx, k-1) - AB_LIMIT];* mit:
*Cgₘᵢₙ:* Minimalwert für die Gesamtkapazität der Energiereserveeinrichtungen
Cg(ϑx, k): die aktuell in der Temperaturklasse ϑx (mit x *ε* (n: niedrig, c: normal, h: hoch)) in der k-ten Messung erfasste Gesamtkapazität;
MWg_CG(ϑx, k-1): der gleitende Mittelwert für die Gesamtkapazität in der Temperaturklasse x basierend auf den k-1.-ten Messungen
AB_LIMIT: Schwellenwert für die Kapazitätsmessung, der auf einen Abriss einer der mindestens zwei Energiereserveeinrichtungen hinweist

Der vorgegebene Schwellenwert AB_LIMIT für die Erkennung des Abrisses einer Energiereserveeinrichtung von mindestens zwei Energiereserveeinrichtungen kann auf einfach und robust in Bezug auf die Maximalkapazität Cgₘₐₓ vorgegebenen werden.

Da eine zusammengefasste Messungenauigkeit von ca. +/- 6,5 % vorliegt, bietet es sich an den Schwellenwert zur Erkennung eines Abrisses an dieser Ungenauigkeit auszurichten. Bspw. durch nachstehenden einfachen und robusten Zusammenhang: $AB_LIMIT = 0,065 \times {Cg}_{max}$

Für das oben angegebene Beispiel mit einer Energiereserveeinrichtung mit einer Gesamtnominalkapazität von Cgn= 6 x 4.5mF = 27mF Nominalkapazität und einer Maximalkapazität von Cgₘₐₓ = 6 0m F folgt für$AB _ LIMIT = 0 , 065 \times 60 mF = 3,9 mF .$

Die Temperaturabhängigkeit kann dabei dadurch berücksichtigt werden, dass mittels der erfassten Temperatur eine Temperaturklasse ϑx ausgewählt wird. Zu jeder Temperaturklasse ϑx kann es einen Mittelwert der Kapazitäten der vorangegangenen Kapazitätsmessungen geben. Bei dem Mittelwert kann es sich um einen gleitenden Mittelwert handeln.

Drei Temperaturklasse ϑx, bspw. ϑn: niedrig (- 40 °C bis 0 °C), ϑc: normal (0 °C bis + 40 °C), ϑh: hoch (+ 40 °C bis + 80 °C), haben sich als ausreichend herausgestellt, um eine verlässliche Abrisserkennung mittels des Verfahrens der vorliegenden Erfindung umzusetzen.

Unter der Berücksichtigung von Temperaturklassen, kann der Schwellenwert für die Erkennung eines Abrisses ein Schwellenwert je Temperaturklasse vorgesehen werden. Dazu kann der gleitende Mittelwert gemäß nachstehender Bedingung gebildet werden:$AB _ LIMIT \left(ϑx\right) = 0 , 065 x MWg _ CG \left(ϑx, k-1\right) ;$ mit
MWg_CG(ϑx, k-1): der gleitende Mittelwert für die Gesamtkapazität in der Temperaturklasse ϑx basierend auf den k-1.-ten Messungen
ϑx: Temperaturklasse mit x *ε* (n: niedrig, c: normal, h: hoch)

Denkbar ist zudem einen Schwellenwert für die Temperatur vorzusehen, bei dessen Überschreiten eine verlässliche Abrisserkennung nicht mehr sinnvoll ist. Dieser Schwellenwert kann bspw. die obere Grenze der heißesten Temperaturklasse sein (bspw. + 80 °C). Oberhalb dieses Schwellenwerts sind die Messfehler bei der Temperaturbestimmung zu groß. Ferner neigen die Toleranzen von Elektrolytkondensatoren bei sehr hohen Temperaturen dazu zu komplex zu werden, als dass eine sinnvolle Abrisserkennung umgesetzt werden könnte. Ist der Schwellenwert ausreichend hoch angesetzt, so sind die real auftretenden Fälle dieser hohen Temperatur unwahrscheinlich.

Wenn im Schritt 104 kein Abriss einer Energiereserveeinrichtung erkannt wurde, dann erfolgt in Schritt 105 die Aktualisierung des gleitenden Mittelwerts. Die Aktualisierung erfolgt dabei temperaturabhängig. Im Falle, dass die Temperaturabhängigkeit mittels Temperaturklassen umgesetzt wird, erfolgt die temperaturabhängige Aktualisierung dadurch, dass mit dem aktuell ermittelten Kapazitätswert der gleitende Mittelwert der zugeordneten Temperaturklasse aktualisiert wird. Die gleitenden Mittelwerte der übrigen Temperaturklassen werden dementsprechend nicht mit dem aktuell ermittelten Kapazitätswert aktualisiert.

Um den gleitenden Mittelwert für Gesamtkapazität robuster zu gestalten kann die aktuell erfasste Gesamtkapazität nur zur Aktualisierung des gleitenden Mittelwerts berücksichtigt, wenn die ermittelte Umgebungstemperatur unterhalb eines vorgegebenen Schwellenwerts für die Umgebungstemperatur liegt.

Als Schwellenwert bietet sich dazu ein Wert von 80 °C an. Oberhalb dieses Wertes ist das Toleranzverhalten von Elektrolytkondensatoren sehr komplex, so dass eine Abrisserkennung mit sinnvollem Ressourceneinsatz nicht möglich ist. Ferner liegen derart hohe Umgebungstemperaturen, insbesondere beim Fahrzeugstart, sehr selten vor.

Um den gleitenden Mittelwert für Gesamtkapazität robuster zu gestalten kann die aktuell erfasste Gesamtkapazität nur zur Aktualisierung des gleitenden Mittelwerts berücksichtigt, wenn die erfasste Gesamtkapazität innerhalb eines vorgegebenen Toleranzbereichs für die mindestens zwei Energiereserveeinrichtungen liegt.

Als Toleranzbereich bietet sich der Bereich der absoluten Minimal- (Cgₘᵢₙ)und Maximalkapazitäten (Cgₘₐₓ) für das Airbagsteuergerät an. Typische Werte sind dabei Cgₘᵢₙ 20 mF = und Cgₘₐₓ = 60 mF.

Um den gleitenden Mittelwert für Gesamtkapazität robuster zu gestalten kann die aktuell erfasste Gesamtkapazität nur zur Aktualisierung des gleitenden Mittelwerts berücksichtigt, wenn die erfasste Gesamtkapazität innerhalb eines vorgegebenen Toleranzbereichs für den von der ermittelten Umgebungstemperatur abhängigen gleitenden Mittelwert für die Gesamtkapazität liegt.

Die temperaturabhängige Erfassung der Kapazität hat eine endliche Größe, daher werden die individuellen Kapazitätsmesswerte eines Steuergerätes auch entsprechend streuen. Ist der Streuwert zu hoch, deutet dies auf eine spezielle Situation hin, die zu einer Störung der Messung führen konnte. Ein solcher Messwert kann durch diese Ausführungsform erkannt werden und dementsprechend nicht für die Aktualisierung des temperaturabhängigen gleitenden Mittelwerts zu berücksichtigt werden.

Für den Toleranzbereich kann bspw. gelten$Cg \left(ϑx, k\right) ε \left[MWg_ Cg\left(ϑx, k-1\right)-0,4 *AB_LIMIT, MWg_ Cg\left(8x, k-1\right)\right.$ $\left.+ 0,4 * AB_LIMIT\right] ;$mit:
Cg(ϑx, k): die aktuell in der Temperaturklasse ϑx (mit x *ε* (n: niedrig, c: normal, h: hoch)) in der k-ten Messung erfasste Gesamtkapazität;
MWg_CG(ϑx, k-1): der gleitende Mittelwert für die Gesamtkapazität in der Temperaturklasse x basierend auf den k-1.-ten Messungen
AB_LIMIT: Schwellenwert für die Kapazitätsmessung, der auf einen Abriss einer der mindestens zwei Energiereserveeinrichtungen hinweist

## Patentansprüche

1. Verfahren (100) zur Erkennung des Abrisses einer Energiereserveeinrichtung, insbesondere eines Kondensators, von mindestens zwei parallel geschalteten Energiereserveeinrichtungen einer Vorrichtung für den Insassenschutz eines Fahrzeugs mit den Schritten:
Laden (101) der mindestens zwei Energiereserveeinrichtungen auf ein Testspannungsniveau (V_Test);
Ermitteln (102) einer Umgebungstemperatur der mindestens zwei Energiereserveeinrichtungen;
Erfassen (103) der Gesamtkapazität der mindestens zwei Energiereserveeinrichtungen;
**dadurch gekennzeichnet, dass** das Verfahren zur Erkennung des Abrisses folgende Schritte aufweist:
Erkennung (104) des Abrisses einer Energiereserveeinrichtung in Abhängigkeit von einem von der ermittelten Umgebungstemperatur abhängigen gleitenden Mittelwert für die Gesamtkapazität und der erfassten Gesamtkapazität;
Aktualisierung (105) eines gleitenden Mittelwerts in Abhängigkeit von der ermittelten Umgebungstemperatur und der erfassten Gesamtkapazität.

2. Verfahren nach Anspruch 1, wobei der Abriss der Energiereserveeinrichtung erkannt wird, wenn die erfasste Gesamtkapazität über einen vorgegebenen Schwellenwert für die Erkennung eines Abrisses hinweg unterhalb des temperaturabhängigen gleitenden Mittelwerts liegt.

3. Verfahren nach Anspruch 1 oder 2, wobei im Schritt des Ermittelns der Umgebungstemperatur ein Temperaturwert eines Temperatursensors einer Sensoreinheit der Vorrichtung erfasst wird, wobei die Sensoreinheit zur Erfassung von auf das Fahrzeug einwirkenden Kräften vorgesehen ist und als Temperatursensor eine Schaltung aufweist, die dazu fähig ist einen Temperaturwert zu erfassen.

4. Verfahren nach einem der vorhergehenden Ansprüche, wobei im Schritt des Ermittelns der Umgebungstemperatur ein Temperaturwert eines Temperatursensors, der eine Innenraumtemperatur des Fahrzeugs erfasst, erfasst wird.

5. Verfahren nach einem der vorhergehenden Ansprüche, wobei im Schritt des Ermittelns der Umgebungstemperatur in Abhängigkeit von den erfassten Temperaturwerten eine Temperaturklasse für einen Temperaturbereich bestimmt wird, und wobei das Erfassen der Gesamtkapazität der mindestens zwei Energiereserveeinrichtungen sowie der temperaturabhängige Vergleich zur Erkennung des Abrisses der Energiereserveeinrichtung auf Basis der zugeordneten Temperaturklasse durchgeführt wird.

6. Verfahren nach Anspruch 5, wobei drei Temperaturklassen für die Temperaturbereiche von - 40 °C bis 0 °C, von 0 °C bis + 40 °C und von + 40 °C bsi + 80 °C verwendet werden.

7. Verfahren nach Anspruch 6, wobei jeder Temperaturklasse ein gleitender Mittelwert für die Gesamtkapazität zugeordnet ist und ein Schwellenwert für die Erkennung eines Abrisses je Temperaturklasse vorgesehen ist, und wobei der Abriss der Energiereserveeinrichtung erkannt wird, wenn die erfasste Gesamtkapazität für die Temperaturklasse über den vorgegebenen Schwellenwert für die Erkennung eines Abrisses hinweg unterhalb des temperaturabhängigen gleitenden Mittelwerts für die Temperaturklasse liegt.

8. Verfahren nach einem der vorhergehenden Ansprüche, wobei im Schritt des Aktualisierens die erfasste Gesamtkapazität nur zur Aktualisierung des gleitenden Mittelwerts berücksichtigt wird, wenn die ermittelte Umgebungstemperatur unterhalb eines vorgegebenen Schwellenwerts für die Umgebungstemperatur liegt.

9. Verfahren nach einem der vorhergehenden Ansprüche, wobei im Schritt des Aktualisierens die erfasste Gesamtkapazität nur zur Aktualisierung des gleitenden Mittelwerts berücksichtigt wird, wenn die erfasste Gesamtkapazität innerhalb eines vorgegebenen Toleranzbereichs für die mindestens zwei Energiereserveeinrichtungen liegt.

10. Verfahren nach einem der vorhergehenden Ansprüche, wobei im Schritt des Aktualisierens die erfasste Gesamtkapazität nur zur Aktualisierung des gleitenden Mittelwerts berücksichtigt wird, wenn die erfasste Gesamtkapazität innerhalb eines vorgegebenen Toleranzbereichs für den von der ermittelten Umgebungstemperatur abhängigen gleitenden Mittelwert für die Gesamtkapazität liegt.

11. Verfahren nach einem der vorhergehenden Ansprüche, wobei das Verfahren zur Erkennung des Abrisses einer Energiereserveeinrichtung von mindestens zwei Energiereserveeinrichtungen bei jedem Fahrzeugstart wiederhohlt wird und der temperaturabhänige gleitende Mittelwert von den vorherigen Fahrzeugstarts stammt.

12. Vorrichtung, welche eingerichtet ist, alle Schritte eines Verfahrens (100) nach einem der Ansprüche 1 bis 11 auszuführen.

13. Computerprogramm umfassend Befehle, die bewirken, dass die Vorrichtung des Anspruchs 12 alle Verfahrensschritte nach einem der Ansprüche 1 bis 11 ausführt.

14. Elektronisches Speichermedium, auf dem das Computerprogramm nach Anspruch 13 gespeichert ist.

## Claims

1. Method (100) for detecting the breakdown of an energy reserve device, in particular of a capacitor, out of at least two energy reserve devices connected in parallel of an apparatus for occupant protection of a vehicle, comprising the steps of:
charging (101) the at least two energy reserve devices to a test voltage level (V_Test);
determining (102) an ambient temperature of the at least two energy reserve devices;
recording (103) the total capacitance of the at least two energy reserve devices;
**characterized in that** the method for detecting the breakdown has the following steps:
detecting (104) the breakdown of an energy reserve device depending on a moving average value for the total capacitance and on the recorded total capacitance, said moving average value being dependent on the determined ambient temperature;
updating (105) a moving average value depending on the determined ambient temperature and the recorded total capacitance.

2. Method according to Claim 1, wherein the breakdown of the energy reserve device is detected if the recorded total capacitance is below the temperature-dependent moving average value beyond a predefined threshold value for the detection of a breakdown.

3. Method according to Claim 1 or 2, wherein in the step of determining the ambient temperature, a temperature value of a temperature sensor of a sensor unit of the apparatus is recorded, wherein the sensor unit is provided for recording forces acting on the vehicle and has, as a temperature sensor, a circuit which is capable of recording a temperature value.

4. Method according to any of the preceding claims, wherein in the step of determining the ambient temperature, a temperature value of a temperature sensor which records an interior temperature of the vehicle is recorded.

5. Method according to any of the preceding claims, wherein in the step of determining the ambient temperature, depending on the recorded temperature values, a temperature class for a temperature range is ascertained, and wherein recording the total capacitance of the at least two energy reserve devices and also the temperature-dependent comparison for detecting the breakdown of the energy reserve device are carried out on the basis of the assigned temperature class.

6. Method according to Claim 5, wherein three temperature classes for the temperature ranges of from -40°C to 0°C, from 0°C to +40°C and from +40°C to +80°C are used.

7. Method according to Claim 6, wherein each temperature class is assigned a moving average value for the total capacitance and a threshold value for the detection of a breakdown is provided per temperature class, and
wherein the breakdown of the energy reserve device is detected if the recorded total capacitance for the temperature class is below the temperature-dependent moving average value for the temperature class beyond the predefined threshold value for the detection of a breakdown.

8. Method according to any of the preceding claims, wherein in the step of updating, the recorded total capacitance is taken into account for updating the moving average value only if the determined ambient temperature is below a predefined threshold value for the ambient temperature.

9. Method according to any of the preceding claims, wherein in the step of updating, the recorded total capacitance is taken into account for updating the moving average value only if the recorded total capacitance is within a predefined tolerance range for the at least two energy reserve devices.

10. Method according to any of the preceding claims, wherein in the step of updating, the recorded total capacitance is taken into account for updating the moving average value only if the recorded total capacitance is within a predefined tolerance range for the moving average value for the total capacitance, said moving average value being dependent on the determined ambient temperature.

11. Method according to any of the preceding claims, wherein the method for detecting the breakdown of an energy reserve device out of at least two energy reserve devices is repeated upon each vehicle start and the temperature-dependent moving average value originates from the previous vehicle starts.

12. Apparatus configured to carry out all the steps of a method (100) according to any of Claims 1 to 11.

13. Computer program comprising instructions which cause the apparatus from Claim 12 to carry out all the method steps according to any of Claims 1 to 11.

14. Electronic storage medium on which the computer program according to Claim 13 is stored.

## Revendications

1. Procédé (100) de détection du claquage d'une unité de réserve d'énergie, en particulier d'un condensateur, d'au moins deux unités de réserve d'énergie montées en parallèle d'un dispositif de protection des occupants d'un véhicule, comprenant les étapes consistant à :
charger (101) lesdites au moins deux unités de réserve d'énergie à un niveau de tension de test (V_Test) ;
déterminer (102) une température ambiante desdites au moins deux unités de réserve d'énergie ;
détecter (103) la capacité totale desdites au moins deux unités de réserve d'énergie ;
**caractérisé en ce que** le procédé de détection du claquage comporte les étapes suivantes consistant à :
identifier (104) le claquage d'une unité de réserve d'énergie en fonction d'une valeur moyenne mobile pour la capacité totale et la capacité totale détectée, qui dépend de la température ambiante déterminée ;
mettre à jour (105) une valeur moyenne mobile en fonction de la température ambiante déterminée et de la capacité totale détectée.

2. Procédé selon la revendication 1, dans lequel le claquage de l'unité de réserve d'énergie est identifié lorsque la capacité totale détectée se situe au-dessous de la moyenne mobile dépendant de la température, au-delà d'une valeur seuil prédéfinie pour la détection d'un claquage.

3. Procédé selon la revendication 1 ou 2, dans lequel, lors de l'étape de détermination de la température ambiante, une valeur de température d'un capteur de température d'une unité de capteur du dispositif est détectée, l'unité de capteur étant prévue pour détecter des forces agissant sur le véhicule et présentant, comme capteur de température, un circuit capable de détecter une valeur de température.

4. Procédé selon l'une des revendications précédentes, dans lequel, lors de l'étape de détermination de la température ambiante, une valeur de température d'un capteur de température qui détecte une température d'habitacle du véhicule est détectée.

5. Procédé selon l'une des revendications précédentes, dans lequel, lors de l'étape de détermination de la température ambiante, une classe de température est déterminée pour une plage de températures en fonction des valeurs de température détectées, et dans lequel la détection de la capacité totale desdites au moins deux unités de réserve d'énergie et la comparaison dépendant de la température pour l'identification du claquage de l'unité de réserve d'énergie sont effectuées sur la base de la classe de température attribuée.

6. Procédé selon la revendication 5, dans lequel trois classes de température sont utilisées pour les plages de température de -40 °C à 0 °C, de 0 °C à +40 °C et de +40 °C à +80 °C.

7. Procédé selon la revendication 6, dans lequel une moyenne mobile pour la capacité totale est attribuée à chaque classe de température et une valeur seuil pour la détection d'un claquage est prévue pour chaque classe de température, et
le claquage de l'unité de réserve d'énergie étant identifié lorsque la capacité totale détectée pour la classe de température se situe au-dessous de la moyenne mobile dépendant de la température pour la classe de température, au-delà de la valeur seuil prédéfinie pour la détection d'un claquage.

8. Procédé selon l'une des revendications précédentes, dans lequel, lors de l'étape de mise à jour, la capacité totale détectée n'est prise en compte pour la mise à jour de la valeur moyenne mobile que lorsque la température ambiante déterminée est inférieure à une valeur seuil prédéfinie pour la température ambiante.

9. Procédé selon l'une des revendications précédentes, dans lequel, lors de l'étape de mise à jour, la capacité totale détectée n'est prise en compte pour la mise à jour de la valeur moyenne mobile que si la capacité totale détectée se trouve dans une plage de tolérance prédéfinie pour lesdites au moins deux unités de réserve d'énergie.

10. Procédé selon l'une des revendications précédentes, dans lequel, lors de l'étape de mise à jour, la capacité totale détectée n'est prise en compte pour la mise à jour de la valeur moyenne mobile que lorsque la capacité totale détectée se situe dans une plage de tolérance prédéfinie pour la moyenne mobile, dépendant de la température ambiante déterminée, pour la capacité totale.

11. Procédé selon l'une des revendications précédentes, dans lequel le procédé de détection du claquage d'une unité de réserve d'énergie parmi au moins deux unités de réserve d'énergie est répété à chaque démarrage du véhicule, et la moyenne mobile dépendant de la température provient de démarrages précédents du véhicule.

12. Dispositif qui est conçu pour exécuter toutes les étapes d'un procédé (100) selon l'une des revendications 1 à 11.

13. Programme informatique, comprenant des instructions qui ont pour effet que le dispositif selon la revendication 12 exécute toutes les étapes du procédé selon l'une des revendications 1 à 11.

14. Support de stockage électronique, sur lequel est stocké le programme informatique selon la revendication 13.
